# EUROPÄISCHE PATENTSCHRIFT

(11) **EP 1 163 379 B1**
(45) Veröffentlichungstag und Bekanntmachung des Hinweises auf die Patenterteilung: **03.07.2002**
(21) Anmeldenummer: 00910756.6
(22) Anmeldetag: 02.03.2000
(51) Int. Cl.: C30B 25/18, C30B 15/00

(54) **HALBLEITERSCHEIBE MIT DÜNNER EPITAKTISCHER SILIZIUMSCHICHT UND HERSTELLUNGSVERFAHREN**
SEMICONDUCTOR WAFER COMPRISING A THIN EPITAXIAL SILICON LAYER AND METHOD FOR PRODUCING SAME
TRANCHE DE SEMICONDUCTEUR PRESENTANT UNE FINE COUCHE DE SILICIUM EPITAXIALE, ET SON PROCEDE DE PRODUCTION

(30) Priorität: 04.03.1999 DE 19909557; 03.02.2000 DE 10004623
(43) Veröffentlichungstag der Anmeldung: 19.12.2001
(73) Patentinhaber: Wacker Siltronic Gesellschaft für Halbleitermaterialien Aktiengesellschaft, 84489 Burghausen (DE)
(72) Erfinder: SCHAUER, Reinhard, D-83410 Laufen (DE); BLIETZ, Markus, D-84529 Tittmoning (DE); VON AMMON, Wilfried, A-5122 Hochburg/Ach (AT); SCHMOLKE, Rüdiger, D-84489 Burghausen (DE)
(74) Vertreter: Rimböck, Karl-Heinz, Dr.
(86) Internationale Anmeldenummer: EP0001800
(87) Internationale Veröffentlichungsnummer: WO0052234

(56) Entgegenhaltungen:
- EP-A- 0 644 588
- EP-A- 0 829 559
- EP-A- 0 959 154

## Beschreibung

Die Erfindung betrifft eine Halbleiterscheibe mit einer dünnen epitaktischen Schicht und ein Verfahren zur Herstellung der Halbleiterscheibe durch Abscheiden der Schicht auf einer Substratscheibe aus einkristallinem Silicium.

Die EP-829559 A1 offenbart ein Verfahren zur Herstellung von Halbleiterscheiben mit geringer Defektdichte, wobei ein Einkristall bereitzustellen ist, der unter Zwangskühlung gezogen werden muß oder eine bestimmte Sauerstoff- und Stickstoff-Konzentration aufweisen muß, und wobei vom Einkristall gewonnene Halbleiterscheiben getempert werden müssen. Die EP-644588 A1 betrifft eine Halbleiterscheibe mit einer epitaxierten Schicht, die eine niedrige Defektdichte aufweist und von einem Einkristall stammt, der mit einer Ziehgeschwindigkeit von höchstens 0,6 mm/min gezogen wurde.

Derzeit sind intensive Untersuchungen im Gang, durch die festgestellt werden soll, welche Merkmale Halbleiterscheiben mit epitaktischer Schicht haben müssen, um sie als Grundmaterial für die Herstellung von modernen CMOS Bauelementen zu qualifizieren. Gemäß der Veröffentlichung in Jpn. J. Appl. Phys. Vol. 36 (1997), pp 2565-2570 ist eine Halbleiterscheibe bestehend aus einer p⁻ - dotierten Substratscheibe und einer ebenfalls p⁻ - dotierten epitaktischen Schicht mit einer Dicke von 1 µm für hoch integrierte CMOS-Anwendungen besonders geeignet. Diese Einschätzung wird auch durch die Veröffentlichung in Electrochemical Society Proceedings Volume 98-1, S.855-861 gestützt. Allerdings wird in diesem Papier auch auf lichtstreuende Defekte (Lichtpunktdefekte) auf der Oberfläche hingewiesen, die bei einer Halbleiterscheibe mit dünner epitaktischer Schicht auftreten, sich aber nicht nachteilig auf den GOI (gate oxide integrity) auswirken. Die genannten Defekte heißen in Fachkreisen LLSs (localized light scatterers). Trotz ihres indifferenten Verhaltens in Bezug auf den GOI sind die LLSs bei den Herstellern von integrierten Schaltkreisen unerwünscht, was sich auch darin zeigt, daß die ITRS (International Roadmap For Semiconductors) verlangt, daß die Anzahl von LLSs mit einer Größe von größer oder gleich 0,085 µm kleiner oder gleich 38 pro Halbleiterscheibe mit epitaktischer Schicht ist. Diese Anforderung gilt für die 0,18 µm Technologie und es ist davon auszugehen, daß mit fortschreitender Miniaturisierung (0,13 µm und kleiner) eine noch schärfere Anforderung an die Anzahl von LLS gestellt werden wird. Darüber hinaus stellt der Grenzwert von 38 LLS einen Maximalwert dar und es ist zu beachten, daß die für die industrielle Prozeßfähigkeit geforderte Zahl deutlich darunter liegen muß.

Die Aufgabe der Erfindung bestand darin, eine Halbleiterscheibe mit epitaktischer Schicht bereitzustellen, die für moderne CMOS-Anwendungen geeignet ist, eine besonders geringe Anzahl an LLSs aufweist und vergleichsweise geringe Herstellungskosten erfordert. Aufgabe der Erfindung ist darüber hinaus, ein Verfahren zur Herstellung der Halbleiterscheibe anzugeben.

Gegenstand der Erfindung ist eine Halbleiterscheibe, bestehend aus einer Substratscheibe aus einkristallinem Silicium und einer darauf abgeschiedenen epitaktischen Schicht, die dadurch gekennzeichnet ist, daß die Substratscheibe einen spezifischen Widerstand von 0,1 bis 50 Ωcm, eine Sauerstoffkonzentration von kleiner als 7,5*10¹⁷ atcm⁻³ und eine Stickstoffkonzentration von 1*10¹³ bis 5*10¹⁵ atcm⁻³ aufweist, und die epitaktische Schicht 0,2 bis 1,0 µm dick ist und eine Oberfläche besitzt, auf der weniger als 30 LLSs-Defekte mit einer Größe von mehr als 0,085 µm nachweisbar sind.
Bevorzugte Ausführungsformen sind in den Ansprüchen 2 und 3 definiert.

Gegenstand der Erfindung ist auch ein Verfahren zur Herstellung einer Halbleiterscheibe gemäß Anspruch 4 oder Anspruch 5. Bevorzugte Ansführungsformen der Verfahren sind in den Ansprüchen 6 bis 12 beansprucht.

Untersuchungen der Erfinder haben ergeben, daß die Kombination der genannten Verfahrensschritte und die Berücksichtigung der genannten Stoffparameter eine Halbleiterscheibe mit epitaktischer Schicht zugänglich macht, die den gestellten Anforderungen in vollem Umfang genügt. Im Hinblick auf die Vermutung, die aus dem genannten Stand der Technik herzuleiten ist, wonach die Anzahl von LLSs nur durch eine möglichst dicke epitaktische Schicht (>=3 µm) gering gehalten werden kann, ist das Ergebnis der Untersuchungen überraschend, weil es zeigt, daß äußerst niedrige LLSs-Dichten auch mit Schichtdicken von 0,2 bis 1 µm möglich sind. Die geringen Schichtdicken und die Tatsache, daß das vorgeschlagene Verfahren ohne einen sogenannten Bake-Schritt vor dem Abscheiden der epitaktischen Schicht auskommt, begründen einen deutlichen Kostenvorteil gegenüber bekannten Verfahren. So kann der Durchsatz an Halbleiterscheiben pro Stunde um bis zum Dreifachen gesteigert werden.

Um die erforderlichen Eigenschaften hinsichtlich der LLSs-Dichte zu erreichen, ist eine Substratscheibe erforderlich, die einen spezifischen Widerstand von 0,1 bis 50 Ωcm, eine Sauerstoff-Konzentration von kleiner als 7,5*10¹⁷ atcm⁻³, besonders bevorzugt von kleiner als 6,5*10¹⁷ atcm⁻³ und eine Stickstoff-Konzentration von 1*10¹³ bis 5*10¹⁵ atcm⁻³, besonders bevorzugt von 1*10¹⁴ bis 5*10¹⁴ cm⁻³ aufweist, und vorzugsweise aus einem nach der Czochralski-Methode gezogenen Einkristall geschnitten wird. Was das Abscheiden der epitaktischen Schicht betrifft, ist wichtig, daß unter Berücksichtigung des Typs der Substratscheibe bei einer Abscheidetemperatur von 1120 bis 1200 °C abgeschieden wird.
Eine erhöhte Abscheidetemperatur hat dabei den prinzipiellen Vorteil einer Reduktion sogenannter "AreaCounts", das heisst großer Fehler auf der epitaktischen Schicht, die zu Ausbeuteverlusten bei den Halbleiterbauelementherstellern führen können.

Ein Einkristall, aus dem Substratscheiben mit den genannten Eigenschaften abgetrennt werden können, kann beispielsweise nach einem Verfahren hergestellt werden, wie es in der DE-198 23 962 A beschrieben ist. Bei dem Verfahren wird der Einkristall nach der Czochralski-Methode aus einer Schmelze gezogen und währenddessen zusätzlich mit Stickstoff dotiert. Gemäß einer Ausführungsform der Erfindung vergehen mindestens 90 min bis gerade kristallisiertes Material des Einkristalls den Temperaturbereich von 1050 bis 900°C durchlaufen hat. Dies ist normalerweise dann der Fall, wenn der Einkristall von sich aus abkühlt, das heißt, auf eine Zwangskühlung des Einkristalls verzichtet wird. Die epitaktische Schicht wird auf einer Substratscheibe, die aus einem solchermaßen gezogenen Einkristall stammt und nachfolgend als Typ I Substratscheibe bezeichnet wird, bei einer Abscheidetemperatur von 1120 bis 1170 °C, vorzugsweise von 1130 bis 1160 °C abgeschieden.

Gemäß einer weiteren Ausführungsform der Erfindung wird der Einkristall nach dem Czochralski-Verfahren gezogen und dabei zwangsgekühlt. Dadurch vergehen höchstens 40 min bis gerade kristallisiertes Material des Einkristalls den Temperaturbereich von 1050 bis 900°C durchlaufen hat. Die Ziehanlage ist mit einer Zwangskühlung zu versehen, um das rasche Abkühlen des Einkristalls zu gewährleisten. Vorzugsweise wird eine Kühlvorrichtung gemäß der EP-725 169 A1 beim Ziehen des Einkristalls verwendet. Die epitaktische Schicht wird auf einer Substratscheibe, die aus einem solchermaßen gezogenen Einkristall stammt und nachfolgend als Typ II Substratscheibe bezeichnet wird, bei einer Abscheidetemperatur von 1120 bis 1200 °C, vorzugsweise von 1130 bis 1190 °C abgeschieden, was einem deutlich breiteren Prozeßfenster in der Epi Abscheidung gegenüber Typ I entspricht und damit eine Optimierung hinsichtlich Wirtschaftlichkeit deutlich erleichtert.

Zum Abscheiden der epitaktischen Schicht wird die Substratscheibe in einen Abscheidereaktor geladen. Bevorzugt ist ein Einzelscheibenreaktor mit automatischem Scheibenbe- und entlademechanismus. Die Temperatur im Reaktor sollte beim Beladen bereits einen vergleichsweise hohen Wert haben, mindestens jedoch 800 °C. Bevorzugt ist eine Temperatur von mindestens 850 °C, besonders bevorzugt eine Temperatur von mindestens 900 °C.

Anschließend wird die Substratscheibe in einer Gasatmosphäre auf eine Abscheidetemperatur aufgeheizt. Die Gasatmosphäre wird vorzugsweise aus einer Gruppe von Gasen ausgewählt, die Wasserstoff, Argon, Helium und beliebige Mischungen der genannten Gase umfaßt. Besonders bevorzugt ist eine Gasatmosphäre aus Wasserstoff.

Sobald die Abscheidetemperatur erreicht ist, wird mit dem Abscheiden der epitaktischen Schicht mit einer Dicke von 0,2 bis 1 µm, bevorzugt 0,3 bis 0,6 µm begonnen, indem der Gasatmosphäre eine Atmosphäre von Abscheidegas und Dotierstoffgas hinzugefügt wird. Ein sogenannter Bake-Schritt, bei dem die Substratscheibe in der Gasatmosphäre einige Zeit, beispielsweise 5 bis 60 s auf Abscheidetemperatur gehalten wird, wird nicht vorgenommen. Das Abscheidegas wird vorzugsweise ausgewählt aus einer Gruppe von Gasen, die Trichlorsilan, Silan , Dichlorsilan, Tetrachlorsilan und beliebige Mischungen der genannten Gase umfaßt. Besonders bevorzugt ist Trichlorsilan. Das Dotierstoffgas wird vorzugsweise ausgewählt aus einer Gruppe von Gasen, die Diboran, Phosphin und Arsin umfaßt. Besonders bevorzugt ist Diboran.

Die Abscheidezeit beträgt vorzugsweise 1 bis 10 s, besonders bevorzugt 1 bis 5 s. Weiterhin ist bevorzugt, den spezifischen Widerstand der epitaktischen Schicht auf 0,5 bis 50 Ωcm einzustellen.

Nach dem Abscheiden der epitaktischen Schicht wird die Halbleiterscheibe vorzugsweise in einer Atmosphäre aus Wasserstoff auf eine Entladetemperatur von vorzugsweise 850 bis 950 °C gebracht und aus dem Abscheidereaktor entladen.

Es können mindestens 50, vorzugsweise bis zu 200 Substratscheiben in Folge beschichtet werden, bevor der Abscheidereaktor mit einem Ätzgas oder einem Plasma gereinigt werden muß.

Erfindungsgemäß hergestellte Halbleiterscheiben wurden im Hinblick auf LLSs mit konventionell hergestellten Halbleiterscheiben verglichen.

### Beispiel:

Die erfindungsgemäß hergestellten Halbleiterscheiben bestanden aus einer Substratscheibe aus Silicium mit einem spezifischen Widerstand von 12 Ωcm (p⁻ - Dotierung), auf die eine epitaktische Schicht mit einer Schichtdicke von 0,5 µm und einem spezifischen Widerstand von 1,5 Ωcm aufgewachsen worden war. Die Abscheidetemperatur betrug von 1130 bis 1190 °C. Die Substratscheiben waren vom Typ I und vom Typ II.

Bei den konventionell hergestellten Halbleiterscheiben stammten die Substratscheiben aus einem Einkristall, der nach der Czochralski-Methode gezogen wurde, ohne daß eine Dotierung mit Stickstoff erfolgte. Substratscheiben aus einem derartig gezogenen Einkristall werden nachfolgend als Referenz I Substratscheiben bezeichnet, wenn der Einkristall ohne Zwangskühlung abgekühlt worden war. Bei den als Referenz II Substratscheiben bezeichneten Substratscheiben wurde der entsprechende Einkristall zwangsgekühlt. Das Abscheiden der epitaktischen Schicht erfolgte unter'denselben Bedingungen wie bei den erfindungsgemäß hergestellten Halbleiterscheiben.

Die nachfolgenden Tabellen 1 und 2 belegen, daß der kombinierten Auswahl von Substratscheibe und Abscheidetemperatur eine entscheidende Bedeutung zufällt, wenn es darum geht die Anzahl von LLSs zu minimieren.

**Tabelle 1:**

| LLS>0.085 µm | Typ I Substratscheibe^{*)} | Referenz I Substratscheibe^{*)} |
|---|---|---|
| 1130°C Abscheidetemp. | 18 (+) | 40 (-) |
| 1190°C Abscheidetemp. | 98 (-) | 1167 (-) |

| | | |
|---|---|---|
| ^{*)} +/-: erfüllt/erfüllt nicht die Anforderungen modernster Bauelemente-Generationen | | |

**Tabelle 2:**

| LLS>0.085 µm | Typ II Substratscheibe^{*)} | Referenz II Substratscheibe^{*)} |
|---|---|---|
| 1130°C Abscheidetemp. | 15 (+) | 820 (-) |
| 1190°C Abscheidetemp. | 12 (+) | 1389 (-) |

| | | |
|---|---|---|
| ^{*)} +/-: erfüllt/erfüllt nicht die Anforderungen modernster Bauelemente-Generationen | | |

Darüber hinaus ist der dramatische Durchsatz-Vorteil der erfindungsgemäß hergestellten Scheiben gegenüber konventionell epitaxierten Scheiben aus Tabelle 3 ersichtlich. Der Durchsatz-Vorteil schlägt sich direkt in einem entsprechenden Kostenvorteil nieder.

**Tabelle 3:**

| | erfindungsgemäße Halbleiterscheibe | Referenzscheibe***) |
|---|---|---|
| Durchsatz(Scheiben / Stunde)**) | 90 | 30 |
| Relative Kosten der Epi Beschichtung pro Scheibe | 0,33 | 1 |

| | | |
|---|---|---|
| **) für einen 3-Kammer Einzelscheiben-Reaktor | | |
| ***) 3 µm Standard Epi | | |

## Patentansprüche

1. Halbleiterscheibe, bestehend aus einer Substratscheibe aus einkristallinern Silicium und einer darauf abgeschiedenen epitaktischen Schicht, **dadurch gekennzeichnet, daß** die Substratscheibe einen spezifischen Widerstand von 0,1 bis 50 Ωcm, eine Sauerstoffkonzentration von kleiner als 7,5*10¹⁷ atcm⁻³ und eine Stickstoffkonzentration von 1*10¹³ bis 5*10¹⁵ atcm⁻³ aufweist, und die epitaktische Schicht 0,2 bis 1,0 µm dick ist und eine Oberfläche besitzt, auf der weniger als 30 LLSs-Defekte mit einer Größe von mehr als 0,085 µm nachweisbar sind.

2. Halbleiterscheibe nach Anspruch 1, **dadurch gekennzeichnet, daß** die Sauerstoffkonzentration der Substratscheibe kleiner als 6,5*10¹⁷ atcm⁻³ ist.

3. Halbleiterscheibe nach Anspruch 1 oder Anspruch 2, **dadurch gekennzeichnet, daß** die Stickstoffkonzentration der Substratscheibe in einem Bereich von 1*10¹⁴ bis 5*10¹⁴ atcm⁻³ liegt.

4. Verfahren zur Herstellung einer Halbleiterscheibe mit einer epitaktischen Schicht durch Abscheiden der Schicht auf einer Substratscheibe aus einkristallinem Silicium, **gekennzeichnet durch** eine Folge von Schritten, umfassend:
das Bereitstellen der Substratscheibe, wobei die Substratscheibe einen spezifischen Widerstand von 0,1 bis 50 Ωcm, eine Sauerstoffkonzentration von kleiner als 7,5*10¹⁷ atcm⁻³ und eine Stickstoffkonzentration von 1*10¹³ bis 5*10¹⁵ atcm⁻³ aufweist; das Aufheizen der Substratscheibe in einem Abscheidereaktor auf eine Abscheidetemperatur von mindestens 1120 °C bis 1170 °C; und
unmittelbar nach dem Erreichen der Abscheidetemperatur das Abscheiden der epitaktischen Schicht mit einer Dicke von 0,2 bis 1,0 µm.

5. Verfahren zur Herstellung einer Halbleiterscheibe mit einer epitaktischen Schicht durch Abscheiden der Schicht auf einer Substratscheibe aus einkristallinem Silicium, **gekennzeichnet durch** eine Folge von Schritten, umfassend:
das Bereitstellen der Substratscheibe **durch** Abtrennen der Substratscheibe von einem Einkristall, der nach dem Czochralski-Verfahren gezogen und dabei zwangsgekühlt wurde, wobei die Substratscheibe einen spezifischen Widerstand von 0,1 bis 50 Ωcm. eine Sauerstoffkonzentration von kleiner als 7,5*10¹⁷ atcm⁻³ und eine Stickstoffkonzentration von 1*10¹³ bis 5*10¹⁵ atcm⁻³ aufweist; das Aufheizen der Substratscheibe in einem Abscheidereaktor auf eine Abscheidetemperatur von 1120 °C bis 1200°C; und
unmittelbar nach dem Erreichen der Abscheidetemperatur das Abscheiden der epitaktischen Schicht mit einer Dicke von 0,2 bis 1,0 µm.

6. Verfahren nach Anspruch 4, **dadurch gekennzeichnet, daß** ein Einkristall gemäß dem Czochralski-Verfahren aus einer Schmelze gezogen wird, und mindestens 90 min vergehen bis der Einkristall den Temperaturbereich von 1050 bis 900°C durchlaufen hat, wobei der Einkristall als Quelle für die Bereitstellung der Substratscheibe dient, und die Abscheidetemperatur beim Abscheiden der epitaktischen Schicht 1120 bis 1170 °C beträgt.

7. Verfahren nach Anspruch 5, **dadurch gekennzeichnet, daß** ein Einkristall gemäß dem Czochralski-Verfahren aus einer Schmelze gezogen wird, und nicht mehr als 40 min vergehen bis der Einkristall unter Anwendung einer Zwangskühlung den Temperaturbereich von 1050 bis 900°C durchlaufen hat, wobei der Einkristall als Quelle für die Bereitstellung der Substratscheibe dient.

8. Verfahren nach Anspruch 7, **dadurch gekennzeichnet, daß** die Abscheidetemperatur 1130 bis 1190 °C beträgt.

9. Verfahren nach einem der Ansprüche 4 bis 8, **dadurch gekennzeichnet, daß** die Substratscheibe in einer Gasatmosphäre auf Abscheidetemperatur aufgeheizt wird, wobei die Gasatmosphäre ausgewählt ist aus einer Gruppe von Gasen, die Wasserstoff, Argon, Helium und beliebige Mischungen der genannten Gase umfaßt.

10. Verfahren nach einem der Ansprüche 4 bis 9, **dadurch gekennzeichnet, daß** die epitaktische Schicht in einer Abscheideatmosphäre abgeschieden wird, die ein Abscheidegas und ein Dotierstoffgas enthält, wobei das Abscheidegas ausgewählt ist aus einer Gruppe von Gasen, die Trichlorsilan, Silan , Dichlorsilan, Tetrachlorsilan und beliebige Mischungen der genannten Gase umfaßt, und das Dotierstoffgas ausgewählt ist aus einer Gruppe von Gasen, die Diboran, Phosphin und Arsin umfaßt.

11. Verfahren nach einem der Ansprüche 4 bis 10, **dadurch gekennzeichnet, daß** die epitaktische Schicht innerhalb von einer Abscheidezeit von 1 bis 10 s abgeschieden wird.

12. Verfahren nach einem der Ansprüche 4 bis 11, **dadurch gekennzeichnet, daß** der Abscheidereaktor frühestens einer Reinigung mit einem Ätzgas oder Plasma unterzogen wird, nachdem auf 50 Substratscheiben in Folge eine epitaktische Schicht abgeschieden worden ist.

## Claims

1. Semiconductor wafer, comprising a substrate wafer made of monocrystalline silicon and an epitaxial layer deposited thereon, **characterized in that** the substrate wafer has a resistivity of from 0.1 to 50 Ωcm, an oxygen concentration of less than 7.5*10¹⁷ atcm⁻³ and a nitrogen concentration of from 1*10¹³ to 5*10¹⁵ atcm⁻³, and the epitaxial layer has a thickness of from 0.2 to 1.0 µm and has a surface on which fewer than 30 LLS defects with a size of more than 0.085 µm can be detected.

2. Semiconductor wafer according to Claim 1, **characterized in that** the oxygen concentration of the substrate wafer is less than 6.5*10¹⁷ atcm⁻³.

3. Semiconductor wafer according to Claim 1 or Claim 2, **characterized in that** the nitrogen concentration of the substrate wafer lies in a range of from 1*10¹⁴ to 5*10¹⁴ atcm⁻³.

4. Process for producing a semiconductor wafer with an epitaxial layer by depositing the layer on a substrate wafer made of monocrystalline silicon, **characterized by** a sequence of steps comprising:
the provision of the substrate wafer, the substrate wafer having a resistivity of from 0.1 to 50 Ωcm, an oxygen concentration of less than 7.5*10¹⁷ atcm⁻³ and a nitrogen concentration of from 1*10¹³ to 5*10¹⁵ atcm⁻³;
the heating of the substrate wafer in a deposition reactor to a deposition temperature of at least 1120°C to 1170°C; and
immediately after the deposition temperature has been reached, the deposition of the epitaxial layer with a thickness of from 0.2 to 1.0 µm.

5. A process for producing a semiconductor wafer with an epitaxial layer by depositing the layer on a substrate wafer made of monocrystalline silicon, **characterized by** a sequence of steps comprising:
the provision of the substrate wafer by seperating the substrate wafer from a single crystal which has been pulled according to the Czochralski process and subjected to forced cooling in this case, the substrate wafer having a resistivity of from 0.1 to 50 Ωcm, an oxygen concentration of less than 7.5*10¹⁷ atcm⁻³ and a nitrogen concentration of 1*10¹³ to 5*10¹⁵ atcm⁻³; the heating of the substrate wafer in a deposition reactor to a deposition temperature of 1120°C to 1200°C; and
immediately after the deposition temperature has been reached, the deposition of the epitaxial layer with a thickness of from 0.2 to 1.0 µm.

6. Process according to Claim 4, **characterized in that** a single crystal is pulled from a melt in accordance with the Czochralski process, and at least 90 min elapse before the single crystal has passed through the temperature range from 1050 to 900°C, the single crystal serving as a source for the provision of the substrate wafer, and the deposition temperature during the deposition of the epitaxial layer is from 1120 to 1170°C.

7. Process according to Claim 5, **characterized in that** a single crystal is pulled from a melt in accordance with the Czochralski process and not more than 40 min elapse before the single crystal, with application of forced cooling, has passed through the temperature range from 1050 to 900°C, the single crystal serving as a source for the provision of the substrate wafer.

8. Process according to Claim 7, **characterized in that** the deposition temperature is from 1130 to 1190°C.

9. Process according to one of Claims 4 to 8, **characterized in that** the substrate wafer is heated to the deposition temperature in a gas atmosphere, the gas atmosphere being selected from a group of gases which includes hydrogen, argon, helium and any desired mixtures of the gases mentioned.

10. Process according to one of Claims 4 to 9, **characterized in that** the epitaxial layer is deposited in a deposition atmosphere containing a deposition gas and a dopant gas, the deposition gas being selected from a group of gases which includes trichlorosilane, silane, dichlorosilane, tetrachlorosilane and any desired mixtures of the gases mentioned, and the dopant gas being selected from a group of gases which includes diborane, phosphine and arsine.

11. Process according to one of Claims 4 to 10, **characterized in that** the epitaxial layer is deposited within a deposition time of from 1 to 10 s.

12. Process according to one of Claims 4 to 11, **characterized in that** the deposition reactor is subjected to cleaning with an etching gas or plasma at the earliest after an epitaxial layer has been deposited on 50 substrate wafers in succession.

## Revendications

1. Pastille semi-conductrice, se composant d'une pastille substrat en silicium monocristallin et d'une couche épitaxiale qui est déposée pardessus, **caractérisée en ce que** la pastille substrat présente une résistance spécifique de 0,1 à 50 Ωcm, une concentration en oxygène inférieure à 7,5*10¹⁷ atcm⁻³ et une concentration en azote de 1*10¹³ à 5*10¹⁵ atcm⁻³, et **en ce que** la couche épitaxiale a une épaisseur de 0,2 à 1,0 µm et possède une surface, sur laquelle moins de 30 défauts LLS d'une taille de plus de 0,085 µm sont détectables.

2. Pastille semi-conductrice selon la revendication 1, **caractérisée en ce que** la concentration en oxygène de la pastille substrat est inférieure à 6,5*10¹⁷ atcm⁻³.

3. Pastille semi-conductrice selon la revendication 1 ou la revendication 2, **caractérisée en ce que** la concentration en azote de la pastille substrat se situe dans un domaine de 1*10¹⁴ à 5*10¹⁴ atcm⁻³.

4. Procédé de fabrication d'une pastille semi-conductrice ayant une couche épitaxiale par dépôt de la couche sur une pastille substrat en silicium monocristallin, **caractérisé par** une séquence d'étapes, comprenant :
la mise à disposition de la pastille substrat, la pastille substrat présentant une résistance spécifique de 0,1 à 50 Ωcm, une concentration en oxygène inférieure à 7,5*10¹⁷ atcm⁻³ et une concentration en azote de 1*10¹³ à 5*10¹⁵ atcm⁻³; le chauffage de la pastille substrat dans un réacteur de dépôt à une température de dépôt d'au moins 1120°C à 1170°C ; et immédiatement après être parvenu à la température de dépôt, le dépôt de la couche épitaxiale ayant une épaisseur de 0,2 à 1,0 µm.

5. Procédé de fabrication d'une pastille semi-conductrice ayant une couche épitaxiale par dépôt de la couche sur une pastille substrat en silicium monocristallin, **caractérisé par** une séquence d'étapes, comprenant :
la mise à disposition de la pastille substrat par tronçonnage de la pastille substrat à partir d'un monocristal, qui a été tiré selon le procédé Czochralski et soumis en l'occurrence à un refroidissement forcé, la pastille substrat présentant une résistance spécifique de 0,1 à 50 Ωcm, une concentration en oxygène inférieure à 7,5*10¹⁷ atcm⁻³ et une concentration en azote de 1*10¹³ à 5*10¹⁵ atcm⁻³ ; le chauffage de la pastille substrat dans un réacteur de dépôt à une température de dépôt de 1120°C à 1200°C ; et
immédiatement après être parvenu à la température de dépôt, le dépôt de la couche épitaxiale ayant une épaisseur de couche de 0,2 à 1,0 µm.

6. Procédé selon la revendication 4, **caractérisé en ce qu'**un monocristal est tiré d'une masse en fusion selon le procédé Czochralski et **en ce qu'**il ne se passe pas plus de 90 minutes jusqu'à ce que le monocristal ait traversé le domaine de température de 1050 à 900°C, le monocristal servant de source en vue de la mise à disposition de la pastille substrat, et la température de dépôt lors du dépôt de la couche épitaxiale étant de 1120 à 1170°C.

7. Procédé selon la revendication 5, **caractérisé en ce qu'**un monocristal est tiré d'une masse en fusion selon le procédé Czochralski, et **en ce qu'**il ne se passe pas plus de 40 minutes jusqu'à ce que le monocristal ait traversé, avec application d'un refroidissement forcé, le domaine de température de 1050 à 900°C, le monocristal servant de source en vue de la mise à disposition de la pastille substrat.

8. Procédé selon la revendication 7, **caractérisé en ce que** la température de dépôt est de 1130 à 1190°C.

9. Procédé selon l'une quelconque des revendications 4 à 8, **caractérisé en ce que** la pastille substrat est chauffée à la température de dépôt dans une atmosphère gazeuse, l'atmosphère gazeuse étant sélectionnée parmi un groupe de gaz, qui comprend l'hydrogène, l'argon, l'hélium et des mélanges quelconques des gaz cités.

10. Procédé selon l'une quelconque des revendications 4 à 9, **caractérisé en ce que** la couche épitaxiale est déposée dans une atmosphère de dépôt, qui contient un gaz de dépôt et un gaz d'agent de dopage, le gaz de dépôt étant sélectionné parmi un groupe de gaz, qui comprend le trichlorosilane, le silane, le dichlorosilane, le tétrachlorosilane et des mélanges quelconques des gaz cités, et le gaz d'agent de dopage étant sélectionné parmi un groupe de gaz, qui comprend le diborane, la phosphine et l'arsine.

11. Procédé selon l'une quelconque des revendications 4 à 10, **caractérisé en ce que** la couche épitaxiale est déposée en l'espace d'un temps de dépôt de 1 à 10 secondes.

12. Procédé selon l'une quelconque des revendications 4 à 11, **caractérisé en ce que** le réacteur de dépôt est soumis à une purification à l'aide d'un gaz de mordançage ou d'un plasma, après qu'une couche épitaxiale a été déposée en séquence sur 50 pastilles substrats.
